# EUROPEAN PATENT APPLICATION

(11) **EP 4 836 304 A1**
(43) Date of publication of application: **04.11.2026**
(21) Application number: 25173158.4
(22) Date of filing: 29.04.2025
(51) Int. Cl.: H03M 3/02, G06G 7/186, H03H 19/00

(54) **SWITCHED-CAPACITOR INTEGRATOR WITH DUAL-CAPACITOR SAMPLING AND DISCHARGE PHASE**

(71) Applicant: Aarhus Universitet, 8000 Aarhus C (DK)
(72) Inventor: Esmailbeygi, Hossein, 8000 Aarhus C (DK); Hatamzadeh, Elham, 8000 Aarhus C (DK); Moradi, Farshad, 8000 Aarhus C (DK)
(74) Representative: Høiberg P/S

(57) **Abstract**

The invention regards a switched capacitor integrator for discrete-time delta-sigma modulators comprising an input terminal and an output terminal, such as an input port and an output port configured to receive an input signal and to generate an output signal, respectively, wherein the switched capacitor integrator comprises a first integrator circuit comprising: one or more sampling capacitive element, wherein said one or more sampling capacitive element comprises a primary sampling capacitive element and an auxiliary sampling capacitive element, a plurality of switches, an operational amplifier comprising a positive input port, a negative input port and an amplifier output port, an integration capacitive element arranged between the negative input port and the amplifier output port. A method of operating a switched capacitor integrator and a sigma-delta modulator comprising an integrator are also disclosed.

## Description

The present invention relates to the field of analogue signal processing, and in particular to switched-capacitor integrators for discrete-time delta-sigma modulators.

### Background

Switched-capacitor (SC) integrators play a fundamental role in discrete-time delta-sigma modulators, where they are used to accumulate sampled input signals and shape quantization noise. In conventional architectures, a single sampling capacitor is employed to capture the input signal during a sampling phase, after which the stored charge is transferred to an integration capacitor during an integration phase. The gain of the integrator is typically set by the ratio between the sampling and integration capacitors, and the size of the sampling capacitor is determined primarily by the thermal noise requirements, governed by the *kT*/*C* relationship. For many precision applications, this necessitates relatively large capacitors to maintain a sufficiently low noise floor, which in turn impacts silicon area and power consumption. To reduce chip area, efforts have been made to use shared-capacitor configurations or implement advanced clocking and charge redistribution schemes.

However, these conventional approaches suffer from important trade-offs. In shared-capacitor configurations, which use a single capacitor for both sampling the input signal and processing reference voltages, there is an inherent leakage path between the analog input and the voltage reference, resulting in performance degradation unless buffered by additional circuitry, which consumes power and adds complexity. Alternatively, architectures employing separate capacitors for sampling and digital-to-analog conversion avoid this leakage but introduce gain errors due to capacitor mismatch, which can be problematic in high-resolution modulators. In both cases, the challenge remains in balancing integrator gain, noise performance, and silicon area. Reducing the gain requires increasing the integration capacitor size, further exacerbating area constraints.

Various techniques have been proposed to address thermal and flicker noise issues or improve power efficiency, such as using inverter-based amplifiers, scaling transconductance, or optimizing clock timing. While these methods provide incremental improvements, they do not fundamentally resolve the core problem: the direct dependency between gain setting and noise performance. The existing architectures fail to offer a flexible means of reducing gain without either increasing the integration capacitor size or compromising the signal-to-noise ratio. Consequently, the design space remains constrained by this trade-off, limiting options for low-power, area-efficient implementations in modern delta-sigma modulators.

It is therefore an objective of the present disclosure to provide a switched-capacitor integrator that allows reduction of the integrator gain without sacrificing noise performance or increasing the required capacitor area.

### Summary

Thus, there exists a need for a switched-capacitor integrator that enables gain reduction without compromising noise performance or increasing chip area. As disclosed here this can be achieved by a switched capacitor integrator for discrete-time delta-sigma modulators comprising an input terminal and an output terminal, such as an input port and an output port configured to receive an input signal and to generate an output signal, respectively, wherein the switched capacitor integrator comprises a first integrator circuit comprising: one or more sampling capacitive element, wherein said one or more sampling capacitive element comprises a primary sampling capacitive element and an auxiliary sampling capacitive element, a plurality of switches, an operational amplifier comprising a positive input port, a negative input port and an amplifier output port, an integration capacitive element arranged between the negative input port and the amplifier output port, wherein the plurality of switches are configured to sample, discharge and/or transfer charges during at least three phases comprising a sampling phase, a discharging phase and an integration phase, wherein the sampling phase is configured to sample a sampling charge from the input terminal to the one or more sampling capacitive element, the discharging phase is configured to discharge an auxiliary charge from the auxiliary sampling capacitive element to a virtual ground and the integration phase is configured to transfer an integration charge from the one or more sampling capacitive elements to the integration capacitive element.

The present disclosure provides a switched-capacitor integrator architecture for use in discrete-time delta-sigma modulators, which enables improved control over gain and noise performance while maintaining area efficiency. The integrator comprises a primary sampling capacitor and an auxiliary sampling capacitor that are both used during the sampling phase to acquire the input signal. The architecture introduces a dedicated discharging phase following the sampling phase, in which the auxiliary sampling capacitor is disconnected from the input signal and discharged to a virtual ground. This ensures that only the charge stored in the primary sampling capacitor is transferred during the integration phase.

By separating the charge acquisition function from the gain-determining function, the integrator allows the designer to decouple the noise-related capacitor sizing from the gain setting. The total sampling capacitance, which defines the noise bandwidth, is determined by the combination of the primary and auxiliary sampling capacitors. However, since only the primary capacitor contributes to the charge transferred during integration, the gain is defined solely by the ratio between the primary sampling capacitor and the integration capacitor. This structure enables the use of smaller primary capacitors for lower gain, without adversely affecting thermal noise performance, and avoids the need to scale the integration capacitor correspondingly.

The disclosed integrator can be implemented using standard CMOS-compatible components, such as transmission gate switches, bootstrapped NMOS devices, and metal-insulator-metal or metal-oxide-metal capacitors. A clocking scheme controls the transitions between the sampling, discharging, and integration phases to ensure proper timing and signal integrity. The integrator may be configured as part of a larger multi-stage delta-sigma modulator, wherein only the first stage employs the disclosed architecture for optimized performance. The invention further allows for additional control features, such as common-mode voltage settings and differential amplifier configurations, to improve linearity and reduce common-mode errors.

The architecture offers substantial benefits in applications where reduced area and low power consumption are critical, particularly in high-resolution sensor interfaces, biomedical electronics, and other noise-sensitive analog-to-digital conversion systems. By enabling flexible gain tuning while preserving noise performance, the disclosed integrator architecture addresses long-standing limitations of conventional switched-capacitor designs.

In another aspect, a delta-sigma modulator comprising the switched capacitor integrator as described herein is disclosed. The delta-sigma modulator further comprises a quantizer and a digital-to-analog converter (DAC) configured to convert a digital output signal coming from the quantizer into a feedback signal, wherein the feedback signal is provided as a feedback input of the integrator.

By incorporating the disclosed integrator into a delta-sigma modulator architecture, several performance advantages are achieved. The improved gain control allows for fine-tuning of the integrator's transfer function without increasing the integration capacitor size, which results in a more compact and area-efficient modulator design. Additionally, the decoupling of noise performance from gain setting enables the use of smaller capacitors and lower power operational amplifiers while maintaining a high signal-to-noise ratio. This makes the modulator particularly well-suited for low-power, high-resolution applications, such as biomedical signal acquisition, sensor interfaces, and portable electronic devices. The resulting architecture enables a flexible and efficient design pathway for delta-sigma modulators targeting strict constraints on noise, area, and power consumption.

In a third aspect, a method of operating a switched capacitor integrator for discrete-time delta-sigma modulator is disclosed, wherein the method comprises the steps of: providing a switched capacitor integrator for discrete-time delta-sigma modulators comprising an input terminal and an output terminal, such as an input port and an output port configured to receive an input signal and to generate an output signal, respectively, wherein the switched capacitor integrator comprises a first integrator circuit comprising: one or more sampling capacitive element, wherein said one or more sampling capacitive element comprises a primary sampling capacitive element and an auxiliary sampling capacitive element, a plurality of switches, an operational amplifier comprising a positive input port, a negative input port and an amplifier output port, an integration capacitive element arranged between the negative input port and the amplifier output port, sampling, during a sampling phase the input signal in the primary and the auxiliary sampling capacitive elements, disconnecting, via the plurality of switches, the auxiliary sampling capacitive element from the input signal, connecting and thereby discharging, via the plurality of switches, during a discharging phase, the auxiliary sampling capacitive element to a virtual ground, and transferring, during an integration phase, an integration charge from the one or more sampling capacitive element to the integration capacitive element.

This method provides a structured timing scheme that separates the sampling, discharging, and integration functions or phases, enabling precise control over the charge handling and signal transfer within the integrator. During the sampling phase, both the primary and auxiliary sampling capacitive elements acquire the input signal, establishing a total capacitance that determines the integrator's thermal noise performance. Before entering the integration phase, the auxiliary sampling capacitive element is disconnected from the input and discharged to a virtual ground. This ensures that only the charge stored on the primary sampling capacitive element is transferred to the integration capacitor, thereby setting the integrator's gain as a function of the ratio between the primary sampling capacitance and the integration capacitance. By allowing the total sampling capacitance to be increased, via the auxiliary sampling capacitive element, without increasing the effective gain, this method supports a favourable trade-off between noise performance and silicon area. As a result, it enables the design of compact, low-power delta-sigma modulators without sacrificing resolution or dynamic range.

### Description of the drawings

In the following embodiment and examples will be described in greater detail with reference to the accompanying drawings:

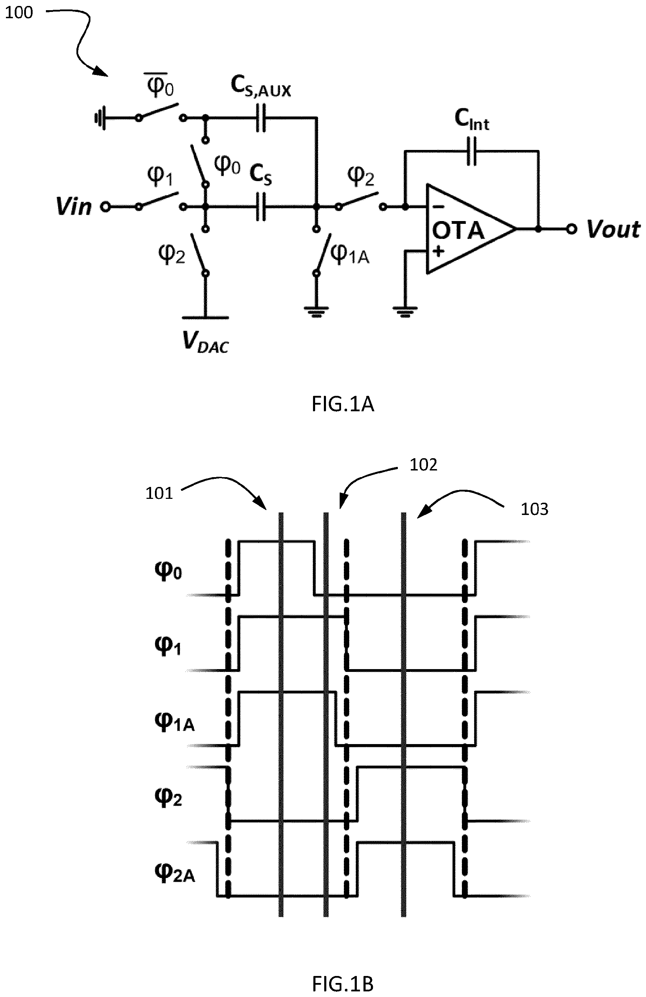

Figs. 1A-B show, respectively, a schematic diagram of an embodiment of a switched-capacitor integrator comprising a primary sampling capacitor, an auxiliary sampling capacitor, an integration capacitor, a plurality of switches, and an operational amplifier (Fig. 1A), and a timing diagram of clock phases used to control the switches during the sampling, discharging, and integration phases of operation (Fig. 1B),

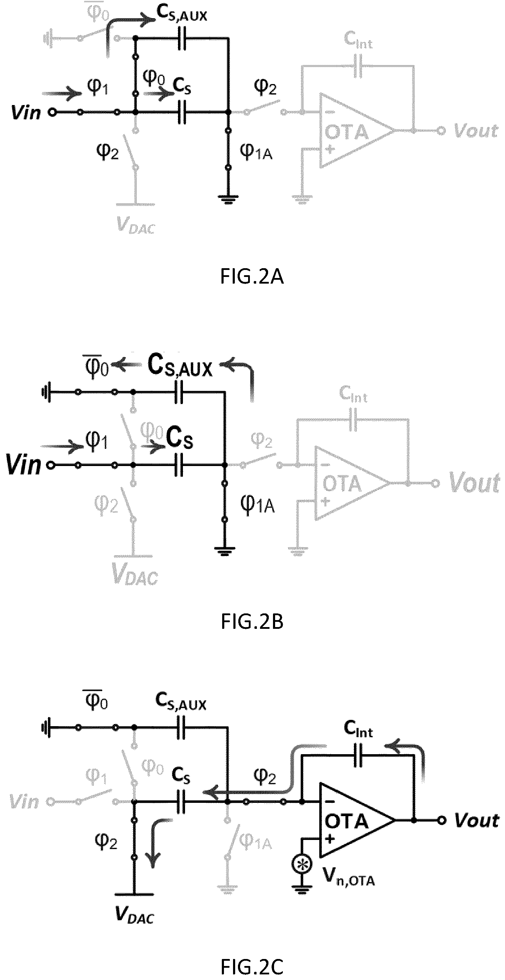

Figs. 2A-C show the operating phases of the switched-capacitor integrator circuit of Fig. 1A, illustrating the sampling phase (Fig. 2A), the discharging phase (Fig. 2B), and the integration phase (Fig. 2C), including the corresponding charge flow directions and active clock phases,

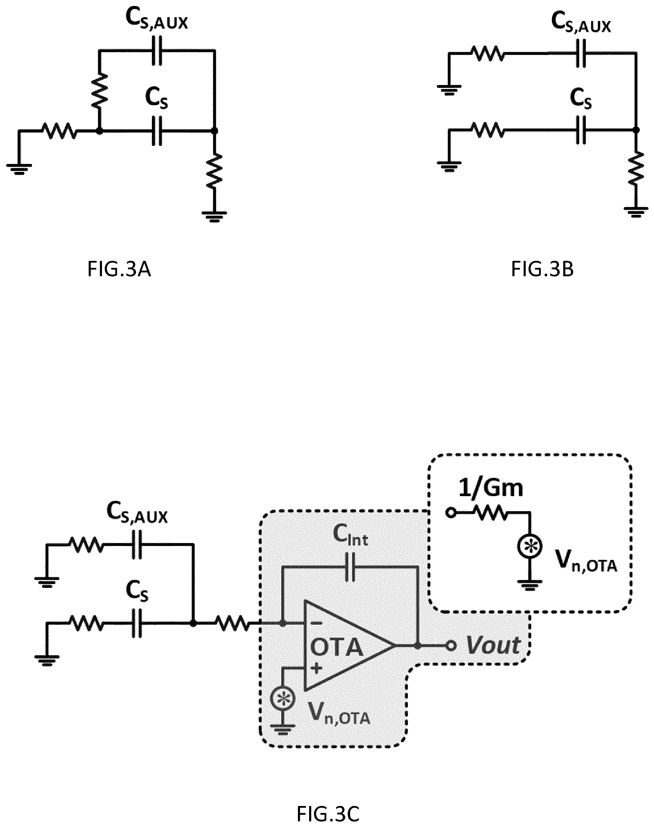

Figs. 3A-C show noise-equivalent circuits of the switched-capacitor integrator during the sampling phase (Fig. 3A), the discharging phase (Fig. 3B), and the integration phase (Fig. 3C), illustrating the effect of the total sampling capacitance and the corresponding noise bandwidth in each operating phase.

### Detailed description

The present disclosure discloses a switched capacitor that may comprise an input terminal and an output terminal, such as an input port and an output port configured to receive an input signal and to generate an output signal, respectively, wherein the switched capacitor integrator comprises a first integrator circuit that may comprise one or more sampling capacitive element, wherein said one or more sampling capacitive element can comprise a primary sampling capacitive element and an auxiliary sampling capacitive element, a plurality of switches, an operational amplifier that can comprise a positive input port, a negative input port and an amplifier output port, an integration capacitive element preferably arranged between the negative input port and the amplifier output port.

The plurality of switches can be configured to sample, discharge and/or transfer charges during at least three phases comprising a sampling phase, a discharging phase and an integration phase, wherein the sampling phase may be configured to sample a sampling charge from the input terminal to the one or more sampling capacitive element, the discharging phase can be configured to discharge an auxiliary charge from the auxiliary sampling capacitive element to a virtual ground and the integration phase may be configured to transfer an integration charge from the one or more sampling capacitive elements to the integration capacitive element.

In one embodiment, the plurality of switches may be individually controlled. This allows each switch to be activated or deactivated according to specific timing requirements associated with the sampling, discharging, and integration phases. Such individual control may be implemented using dedicated control signals for each switch, enabling precise management of the charge transfer paths throughout the different operating phases of the integrator.

In another embodiment, the integration capacitive element and/or the one or more sampling capacitive element comprise an integration capacitor and/or one or more sampling capacitor, and wherein the primary sampling capacitive element and the auxiliary sampling capacitive element comprise a primary sampling capacitor and an auxiliary sampling capacitor, respectively. The integration capacitive element and the one or more sampling capacitive elements may comprise, respectively, an integration capacitor and one or more sampling capacitors. The sampling capacitors may include a primary sampling capacitor and an auxiliary sampling capacitor. This terminology reflects conventional capacitor-based implementations used in switched-capacitor circuits, where each capacitive element corresponds to a distinct physical capacitor configured for specific roles within the integrator.

In a preferred embodiment, the integration capacitor and/or the one or more sampling capacitors may be implemented using CMOS-compatible capacitor structures. Suitable technologies for realizing such capacitors include metal-insulator-metal (MiM) capacitors, metal-oxide-metal (MoM) capacitors, and MOS capacitors. These capacitor types are commonly available in standard CMOS processes and can be selected based on trade-offs involving linearity, matching, capacitance density, and parasitic behavior.

Different CMOS capacitor types may offer distinct advantages depending on the performance requirements of the integrator. For example, metal-insulator-metal (MiM) capacitors are often preferred in applications where high linearity is desired, due to their stable capacitance over voltage and temperature variations. This makes them particularly suitable for use in integrator stages of delta-sigma modulators, where nonlinearity can directly degrade signal fidelity. Metal-oxide-metal (MoM) capacitors may offer higher capacitance density and are often selected where area efficiency is a priority, albeit sometimes at the expense of linearity. MOS capacitors, while compact and readily available, can exhibit more pronounced voltage dependence and may therefore be more suitable for auxiliary roles or non-critical paths in the circuit. The choice of capacitor type may thus be adapted depending on the specific role of the capacitive element within the integrator and the targeted trade-off between area, linearity, and process compatibility.

The switched-capacitor integrator may further comprise a master clock. The master clock may be configured to provide and/or generate a plurality of clock signals configured to control the plurality of switches, preferably the operation of the plurality of switches. These clock signals may define non-overlapping time intervals corresponding to the sampling phase, discharging phase, and integration phase. The use of a master clock allows the integrator to be synchronized with other components in a delta-sigma modulator system and ensures correct phase alignment for consistent charge manipulation across switching cycles.

In some embodiments, the master clock may be generated using conventional timing generation techniques known in the field of delta-sigma modulators. For instance, the master clock may be derived from an on-chip phase-locked loop (PLL) or delay-locked loop (DLL), which can provide a stable and accurate high-frequency clock based on an external reference signal. A PLL-based implementation may be advantageous where low jitter or precise frequency control is required, while a DLL may offer improved duty cycle stability and lower power consumption in certain applications. Alternatively, a ring oscillator may be employed, particularly in fully integrated or low-power systems, where compactness and ease of implementation in standard CMOS processes are beneficial. In other embodiments, the master clock may be externally supplied and subsequently processed on-chip using frequency dividers or non-overlapping clock generators to derive multiple clock phases. These phases may include a plurality of clock signals, which are timed to control the sampling, discharging, and integration operations of the switched-capacitor integrator. In multi-stage delta-sigma modulators, delayed or multiphase clock signals may further be generated using shift-register-based delay lines or cascaded logic circuits to coordinate timing across stages. This may be particularly relevant in architectures that rely on pipelined or cascaded integrator feedforward configurations, where precise alignment of sampling and integration events is required for correct operation.

In one embodiment, the operation of the switched-capacitor integrator may be organized into at least three sequential phases, namely a sampling phase, a discharging phase, and an integration phase. These phases may occur in that specific order within each clock cycle to ensure proper charge acquisition, isolation, and transfer. During the sampling phase, the input signal is sampled onto the capacitive elements. In the following discharging phase, the auxiliary sampling capacitor is decoupled from the input and discharged to a virtual ground, thereby preventing it from contributing to the integration phase. Finally, during the integration phase, the charge stored on the primary sampling capacitor is transferred to the integration capacitor via the operational amplifier, defining the integrator's gain independently of the total sampling capacitance.

In another embodiment, the plurality of switches comprises a first part, a second part and a third part of switches. These groupings may correspond to switches primarily responsible for the sampling, discharging, and integration phases, respectively. For instance, the first part may include switches that connect the sampling capacitive elements to the input terminal, the second part may include switches that enable discharging of the auxiliary capacitor to a virtual ground, and the third part may include switches that connect the sampling capacitive elements to the integration capacitive element and the operational amplifier. This partitioning of the switches may facilitate implementation of non-overlapping clock phases and simplify timing control in both physical layout and signal routing. Some of the plurality of switches can be comprised in at least two groups, such that some of the plurality of switches can for instance be comprised in the first part and in the second part, or in the second part and in the third part. Some of the plurality of switches can also be comprised in all parts.

The virtual ground used during the discharging phase may, in one embodiment, be implemented as an alternating current (AC) ground. This AC ground may correspond to a low-impedance node at signal frequencies. Using an AC ground may improve the discharge efficiency and signal isolation while minimizing any residual voltage offset that could otherwise affect charge transfer accuracy in subsequent phases.

Ideally, the AC impedance between the auxiliary sampling capacitive element and the AC ground to which it is discharged may be minimized to promote efficient removal of the stored charge during the discharging phase. A low-impedance discharge path allows the auxiliary capacitor to be rapidly and reliably brought to a defined potential within the limited time allocated for this phase. If the discharge is incomplete-due, for example, to limited discharge time or higher impedance-a residual charge may remain on the auxiliary capacitor. This residual charge can be transferred to the integration capacitor in the subsequent integration phase, resulting in a gain error that is dependent on the ratio between the auxiliary and primary sampling capacitances and the duration of the discharging phase. While this may affect the effective gain and the positioning of the loop filter poles in a delta-sigma modulator, it generally does not significantly impact the linearity of the system and can be controlled by adjusting the timing of the discharging interval. Maintaining a sufficiently low AC impedance and a suitable discharge duration therefore supports stable and predictable integrator behaviour.

In a preferred embodiment, the sampling phase is configured to cause the plurality of switches to form a series connection between the input terminal, the one or more sampling capacitive elements arranged in parallel, and a sampling virtual ground, wherein the sampling virtual ground is a sampling AC ground. During the sampling phase, the integrator may be configured such that the plurality of switches form a conductive path between the input terminal, the primary and auxiliary sampling capacitive elements arranged in parallel, and a sampling virtual ground. This sampling virtual ground may also be implemented as an AC ground to ensure that the input signal is sampled across a well-defined potential difference, minimizing distortion and preserving the integrity of the acquired charge. The use of a parallel configuration for the capacitive elements during this phase helps achieve the desired thermal noise performance by maximizing the total capacitance exposed to the input signal.

In one embodiment, the discharging phase is configured to cause the plurality of switches to form at least one series connection between the input terminal, the virtual ground and/or the sampling virtual ground, thereby discharging the charges of the auxiliary sampling capacitive element into the virtual ground and/or the sampling virtual ground. The discharging phase may be implemented by configuring the plurality of switches to form a series connection involving the input terminal and one or more virtual grounds, such as a main virtual ground or a sampling virtual ground. This configuration allows the auxiliary sampling capacitive element to discharge its stored charge into a controlled low-impedance node, preferably AC low-impedance node.

In another embodiment, the integration phase is configured to cause the plurality of switches to form a series connection between at least one virtual ground, the one or more sampling capacitive elements, the integration capacitive element and the output terminal, thereby transferring the integration charge from the one or more sampling capacitive elements to the integration capacitive element.

In one embodiment, the primary sampling capacitive element is connected to a primary virtual ground, such as a primary alternative current (AC) ground, preferably a primary direct current (DC) bias. This primary virtual ground may be an alternating current (AC) ground, such as the virtual short at the inverting input of an operational amplifier. In some implementations, the primary virtual ground may further be associated with a defined direct current (DC) bias level, which stabilizes the common-mode voltage at the integrator's internal nodes. The combination of AC grounding and DC biasing may assist in minimizing charge injection errors and voltage-dependent effects across the sampling capacitor.

In a preferred embodiment, the operational amplifier is configured to have the one or more sampling capacitive elements and/or the integration capacitive elements connected to its negative input via the plurality of switches, and wherein the positive input is connected to a local AC ground. This differential arrangement can be used in integrator circuits to establish a virtual ground at the negative input and facilitate accurate charge transfer. The AC ground at the positive input may serve as a stable reference, ensuring that the operational amplifier maintains its intended feedback behavior during each operating phase.

The switches used to configure the sampling, discharging, and integration paths may be implemented using CMOS-based switch architectures. These switches are typically integrated in standard CMOS processes and may consist of various configurations depending on performance requirements. In some embodiments, each switch may be realized as a transmission gate, which combines a complementary NMOS and PMOS pair to achieve symmetrical conduction for both voltage polarities. In other cases, the switches may be implemented using a single NMOS or PMOS transistor, or a bootstrapped NMOS transistor to reduce the on-resistance and improve signal fidelity. The choice of switch type may depend on factors such as signal swing, linearity, clock feedthrough, and layout constraints.

In one embodiment, the plurality of switches used to control the operation of the integrator may comprise at least six distinct switches. These switches may be designated for controlling the various phases of operation, sampling, discharging, and integration, and may be individually associated with specific capacitive connections. The use of six or more switches allows for flexible and isolated signal paths to be defined at each stage of the integrator's operation, reducing the likelihood of charge sharing, parasitic coupling, or signal interference between phases.

The first switch may be configured to selectively connect or disconnect the primary sampling capacitive element to the input terminal of the integrator. This switch may be closed during the sampling phase, allowing the input signal to be sampled across the primary capacitor, and opened during the subsequent phases to isolate the input from internal charge redistribution events.

The second switch may be arranged to connect or disconnect the primary sampling capacitive element to a primary virtual ground. This virtual ground may be implemented as an AC ground and may optionally be associated with a defined DC bias voltage to stabilize the common-mode level at the sampling node. By controlling this connection, the second switch can ensure that the charge on the primary sampling capacitor is referenced to a known potential, facilitating accurate charge transfer during the integration phase.

The third switch may be configured to connect or disconnect the primary sampling capacitive element to the auxiliary sampling capacitive element. During the sampling phase, this switch may be closed to allow both capacitive elements to be exposed to the input signal simultaneously, maximizing the effective sampling capacitance. In the discharging phase, the third switch may be opened to decouple the auxiliary capacitor from the primary path before it is discharged, preventing any back-injection of charge during the integration phase.

The fourth switch may serve to connect or disconnect the auxiliary sampling capacitive element to a virtual ground. This switch may be closed during the discharging phase, allowing the auxiliary capacitor to release its stored charge to a low-impedance node, such as the inverting input of the operational amplifier. This selective discharge mechanism is important for ensuring that only the charge from the primary capacitor contributes to the integration phase, thereby defining the effective integrator gain.

The fifth switch may be configured to connect the one or more sampling capacitive elements to the integration capacitive element and/or to the negative input of the operational amplifier. This switch may be activated during the integration phase, enabling the transfer of charge from the sampling side of the circuit to the integration node, where it is accumulated and contributes to the output signal.

The sixth switch may be provided to connect the one or more sampling capacitive elements to a sampling virtual ground. The sampling virtual ground may be defined as an AC ground, and in some embodiments, it may further be stabilized with a DC bias. The sixth switch may be used during the sampling or discharging phases to provide a known reference potential for charge distribution or isolation, depending on the timing scheme and desired signal conditioning behavior.

In one embodiment, the second switch and the fifth switch are controlled by a second control signal. The control of the switching sequence may be implemented using a set of dedicated timing signals, where two or more switches are controlled by the same signal to simplify the timing logic. For instance, the second switch and the fifth switch may be jointly controlled by a second control signal. This arrangement ensures that both switches are activated or deactivated in synchrony, allowing coordinated charge transfer between the sampling capacitive elements and the integration stage at appropriate moments in the clock cycle.

In another embodiment, the third switch and the fourth switch are controlled by complementary signals, such that a first control signal is split into two complementary signals, each controlling one of the third switch and the fourth switch. In such a case, a single control signal may be split into two complementary versions, each controlling one of the third and fourth switches, respectively. This configuration can allow precise and mutually exclusive control over the connection between the primary and auxiliary sampling capacitors on the one hand, and the discharge path to the virtual ground on the other. By ensuring that these two switches do not conduct simultaneously, undesired charge leakage or interference between the sampling and discharging paths can be avoided.

In some implementations, the timing of the switches may be defined in terms of distinct phases. For instance, in another embodiment, the sampling phase is configured to close the first, the third and the sixth switches and open the second, the fourth and the fifth switches. During the sampling phase, the first, third, and sixth switches may be closed, establishing a conductive path between the input terminal, the parallel sampling capacitors, and the sampling virtual ground. At the same time, the second, fourth, and fifth switches may be open, isolating the charge acquisition path from both the integration and discharging paths.

In the discharging phase, the fourth, first, and sixth switches may be closed, enabling the auxiliary sampling capacitor to discharge through a low-impedance path to the virtual ground. Concurrently, the third, second, and fifth switches may be opened to isolate the primary sampling capacitor from the auxiliary sampling capacitor and the integration path, preventing any unintended charge transfer during discharge.

Finally, during the integration phase, the fourth, second, and fifth switches may be closed, forming a series connection between the one or more sampling capacitor and the integration capacitor. Meanwhile, the first, third, and sixth switches may be opened, effectively isolating the input terminal from the charge transfer path. This sequence allows only the remaining charge stored on the one or more sampling capacitor to be transferred to the integration capacitor, thereby defining the integrator's effective gain.

In one embodiment, the operational amplifier is an operational transconductance amplifier (OTA). OTAs are particularly suitable for integration in CMOS technologies and are commonly used in switched-capacitor circuits due to their ability to provide high gain with low power consumption. The transconductance characteristic of the OTA facilitates linear charge transfer during the integration phase and supports the establishment of a virtual ground at the inverting input node.

In a preferred embodiment, the operational amplifier is a fully differential operational amplifier, such as a fully differential operational transconductance amplifier. A fully differential architecture may improve common-mode rejection and reduce even-order harmonic distortion, which can be particularly beneficial in delta-sigma modulator applications where high linearity and dynamic range are desired. In some cases, the amplifier may be a fully differential OTA, combining the advantages of both differential signaling and transconductance-based amplification.

The fully differential amplifier may comprise a differential amplifier input and a differential amplifier output. This configuration allows the integrator to process differential input signals and produce differential output signals, improving signal integrity and noise immunity. Such a differential configuration is particularly advantageous in systems where external interference or coupling is a concern, and where downstream stages also operate in a differential domain.

In a preferred embodiment, the switched-capacitor integrator may comprise a second integrator circuit, wherein the second integrator circuit comprises the same features as the first integrator circuit. The second integrator circuit may be configured to have the same structural and functional features as the first integrator circuit. Each integrator circuit, such as the first integrator circuit or the second integrator circuit, may be associated with one input of a fully differential operational amplifier and may include its own primary and auxiliary sampling capacitive elements, switches, and integration capacitive elements. The use of such a differential configuration enables the circuit to process signals in a balanced manner, thereby improving common-mode noise rejection, linearity, and dynamic range. The symmetrical structure of the first and second integrator circuits supports accurate differential operation and facilitates integration in systems where high immunity to external interference and precise signal reproduction are desired.

In another embodiment, at least two of the plurality of switches are configured to provide a common-mode direct current (DC) voltage, and wherein one of the at least two of the plurality of switches is arranged between a common-mode voltage port and the positive input port, and another one of the at least two of the plurality of switches is arranged between the common-mode DC voltage port and the negative input port. For example, one switch may be arranged to connect a common-mode voltage port to the positive input port, while another switch may connect the same common-mode voltage port to the negative input port. These connections may be used to establish a desired bias condition at the operational amplifier inputs, ensuring that both input terminals operate around a defined voltage level. This helps stabilize the switched-capacitor integrator's operating point and supports proper functioning of the operational amplifier across all operating phases.

The primary and auxiliary sampling capacitors may have different capacitance values. In particular, the auxiliary sampling capacitance may be greater than the primary sampling capacitance, such that their ratio is greater than one. This ratio may be selected based on the desired balance between gain and noise performance. For example, the auxiliary sampling capacitance may be equal to or greater than two, three, four, five, or even ten times the primary sampling capacitance. A higher auxiliary capacitance increases the total sampling capacitance during the sampling phase, thereby improving thermal noise performance, while allowing the gain, defined by the smaller primary capacitor, to remain low. This enables area-efficient gain control without compromising noise characteristics.

In the context of the present disclosure, and for all aspects disclosed, the term virtual ground and/or AC ground refers broadly to any node within the circuit that provides a low-impedance path for alternating current (AC) signals. This may include, for example, the inverting input of an operational amplifier configured with negative feedback, a common-mode reference node in a fully differential amplifier, a stabilized internal bias voltage, or any other node that is held at a sufficiently constant AC potential during one or more phases of the integrator operation. In some embodiments, multiple virtual grounds, such as those used during sampling, discharging, and integration phases, may refer to the same physical node, or may be implemented as distinct low-impedance nodes depending on circuit architecture and timing requirements.

In another aspect, a delta-sigma modulator is disclosed, wherein the delta-sigma modulator may comprise the switched-capacitor integrator as described in any of the preceding embodiments. The delta-sigma modulator may further include a quantizer configured to receive the output signal of the integrator and generate a corresponding digital output signal. This digital output may then be fed into a digital-to-analog converter (DAC), which is arranged to produce an analog feedback signal that is provided as an input to the integrator. The resulting closed-loop configuration allows the delta-sigma modulator to shape quantization noise and achieve high-resolution analog-to-digital conversion. The integrator, operating within this loop, serves to accumulate the difference between the analog input signal and the feedback signal, thereby enabling precise modulation of the quantizer input and enhancing the overall signal fidelity of the modulator. The delta-sigma modulator, that can comprise the integrator, may benefit from the benefits of the integrator as disclosed and described herein, which can be improved control over gain and noise performance and reduced chip area through the use of one or more sampling capacitors and the implementation of a discharging phase. Additionally, the integrator allows for decoupling of the thermal noise constraint from the gain-setting mechanism, enabling the use of larger total sampling capacitance without increasing the effective gain. This contributes to high-resolution operation with reduced power consumption and supports efficient implementation in compact, low-voltage CMOS technologies.

In one embodiment, the delta-sigma modulator may further comprise a positive voltage reference and a negative voltage reference, wherein the positive voltage reference and the negative voltage reference can be supplied to the one or more sampling capacitors through a positive voltage reference switch and a negative voltage reference switch, respectively, and wherein the positive voltage reference switch and the negative voltage reference switch have the same features as the plurality of switches. The positive voltage reference and the negative voltage reference can be used to establish defined reference levels for the feedback path and/or the input signal sampling. These reference voltages may be selectively connected to the one or more sampling capacitors through respective reference switches, namely a positive voltage reference switch and a negative voltage reference switch. These switches may be implemented with the same design features as the plurality of switches used in the integrator, for instance including CMOS-based transmission gates or bootstrapped NMOS devices. This consistent switch architecture ensures matching electrical characteristics across signal paths, which may be beneficial for linearity and charge injection balance. The provision of selectable reference voltages through controlled switching enables flexible signal scaling and allows the modulator to operate within a defined voltage range suitable for the target application and process constraints.

In a third aspect, a method of operating a switched capacitor integrator for discrete-time delta-sigma modulator is disclosed, wherein the method can comprise the steps of: providing a switched capacitor integrator for discrete-time delta-sigma modulators comprising an input terminal and an output terminal, such as an input port and an output port configured to receive an input signal and to generate an output signal, respectively, wherein the switched capacitor integrator comprises a first integrator circuit comprising: one or more sampling capacitive element, wherein said one or more sampling capacitive element comprises a primary sampling capacitive element and an auxiliary sampling capacitive element, a plurality of switches, an operational amplifier comprising a positive input port, a negative input port and an amplifier output port, an integration capacitive element arranged between the negative input port and the amplifier output port, sampling, during a sampling phase the input signal in the primary and the auxiliary sampling capacitive elements, disconnecting, via the plurality of switches, the auxiliary sampling capacitive element from the input signal, connecting and thereby discharging, via the plurality of switches, during a discharging phase, the auxiliary sampling capacitive element to a virtual ground, and transferring, during an integration phase, an integration charge from the one or more sampling capacitive element to the integration capacitive element.

In one embodiment, the discharging phase is between the sampling phase and the integration phase. The discharging phase may be temporally positioned between the sampling phase and the integration phase. This ordering ensures that the auxiliary sampling capacitive element is fully isolated from the input and discharged before any charge transfer occurs to the integration capacitor, thereby avoiding unintended contributions to the integrated signal and allowing the integrator gain to be determined solely by the primary sampling capacitive element.

In another embodiment, the virtual ground is a virtual alternating current (AC) ground. More generally, a virtual AC ground may be any node within the circuit that provides a low-impedance path for AC signals during a given operating phase. For example, the discharge path may be formed through the inverting input of an operational amplifier configured with negative feedback, which can act as an AC ground due to its high loop gain. Alternatively, the virtual ground may correspond to a stabilized common-mode voltage node, an internal bias reference, or another circuit node held at a sufficiently constant AC potential. This configuration helps establish a reliable reference for discharging the auxiliary sampling capacitor and ensures consistent and controlled charge removal during each clock cycle, independent of the specific implementation used.

In a preferred embodiment, the plurality of switches comprises a first, a second and a third set of one or more switch. The plurality of switches involved in implementing this method may be logically grouped into at least three distinct sets. A first set of switches may be used during the sampling phase to form the sampling path, a second set may be employed during the discharging phase to connect the auxiliary sampling capacitive element to the virtual ground, and a third set may be used during the integration phase to establish the charge transfer path from the sampling capacitive elements to the integration capacitive element. This division of switching responsibilities allows for precise control of the timing and function of each phase in the integrator's operation.

In one embodiment, the first set of one or more switch is forming a sampling path between the input terminal, the primary sampling capacitor and the auxiliary sampling capacitor arranged in parallel, and a sampling virtual ground, during the sampling phase. During the sampling phase, the first set of one or more switches may be configured to form a sampling path that connects the input terminal to both the primary and auxiliary sampling capacitors, which may be arranged in parallel. This configuration allows the input signal to be sampled simultaneously across both sampling capacitive elements, thereby ensuring that the total sampling capacitance is maximized to achieve the desired thermal noise performance. The sampling path may also include a connection to a sampling virtual ground, which serves as a stable reference potential during the acquisition of the input signal.

The sampling virtual ground used in this configuration may be implemented as a sampling alternating current (AC) ground. In practice, such an AC ground may correspond to a low-impedance node within the circuit. The use of an AC ground at this point helps ensure that the voltage across the sampling capacitors is accurately defined during the sampling phase, thereby improving linearity and minimizing distortion or charge injection errors.

In another embodiment, the second set of one or more switch is forming a discharging path between the input terminal, the primary sampling capacitor, the auxiliary sampling capacitor, and the virtual ground, during the discharging phase. During the discharging phase, the second set of one or more switches may be arranged to form a discharging path. This path may include connections between the input terminal, the primary and auxiliary sampling capacitors, and the virtual ground. By activating this configuration, the auxiliary sampling capacitor can be disconnected from the input signal and discharged to a stable reference potential, such as the virtual ground of the amplifier. The primary sampling capacitor may remain electrically isolated or may also be referenced in a way that ensures it retains its sampled charge for the subsequent integration phase.

In some embodiments, the second set of switches may additionally be configured to form a series connection between the parallel combination of the primary and auxiliary sampling capacitors and the sampling virtual ground. This series connection facilitates controlled discharge of the auxiliary capacitor while maintaining the primary capacitor's integrity. By routing the discharge through a defined low-impedance path, this configuration ensures that any residual charge on the auxiliary capacitor is efficiently removed, thereby preserving the accuracy of the integration phase and contributing to stable and repeatable operation across clock cycles.

In one embodiment, the third set of one or more switch is forming an integration path between the output terminal, the integration capacitor, the primary sampling capacitor and a primary AC ground. This configuration allows the charge stored on the primary sampling capacitor, following the sampling and discharging phases, to be transferred to the integration capacitor. The primary AC ground may serve as a stable reference potential that facilitates accurate charge redistribution and contributes to linear and predictable integrator behaviour.

In another embodiment, the third set of one or more switch is further forming a series connection between the integration capacitor, the auxiliary sampling capacitor, and the virtual ground. This configuration allows the auxiliary sampling capacitor to remain connected to the integration path in a controlled manner, even after being discharged in the preceding phase. While the gain of the integrator is determined by the charge transferred from the primary sampling capacitor, the presence of the auxiliary sampling capacitor during the integration phase contributes to maintaining the total capacitance seen by the operational amplifier. This assists in preserving the thermal noise performance of the integrator without requiring a proportionally large integration capacitor. By enabling the auxiliary capacitor to participate in the integration configuration, without contributing to the gain-defining charge transfer, the circuit achieves a favourable trade-off between area efficiency and noise reduction, as particularly beneficial in low-power or high-resolution delta-sigma modulator designs that would preferably include the switched-capacitor integrator as described herein.

The method of operating the switched-capacitor integrator, as described above, may be carried out by the switched-capacitor integrator as described herein. This ensures that the functional behaviour outlined in the method claims is fully supported by the corresponding circuit structures, including, but not limited to, the use of primary and auxiliary capacitive elements, the organization of the switching network, the sequencing of operating phases, and the various reference potentials used throughout the integrator cycle.

### Detailed description of the drawings

Figs. 1A-B illustrate an embodiment of a switched-capacitor integrator circuit 100 and its associated timing diagram, respectively. Fig. 1A shows the integrator circuit comprising a primary sampling capacitor C_{S}, an auxiliary sampling capacitor C_{S,AUX}, and an integration capacitor Cᵢₙₜ. The integrator further comprises a plurality of switches configured to selectively connect nodes in the circuit to various signal sources and reference potentials under the control of non-overlapping clock signals.

The input signal Vin is applied at the input terminal and sampled onto both the primary capacitor C_{S} and the auxiliary capacitor C_{S,AUX} during a sampling phase. The charge sampling is controlled by switches governed by the clock phases φ0, φ1, and φ1A. In particular, φ1 connects Vin to the lower terminal of C_{S}, and φ0 controls the top plate of both C_{S} and C_{S,AUX}, allowing them to sample the input voltage simultaneously. The auxiliary capacitor is connected in parallel with the primary capacitor during this phase. The lower terminal of the auxiliary capacitor is connected to ground through a switch controlled by /φ0, which is the complement of φ0.

The DAC reference voltage V_{DAC} is shown connected through a switch driven by φ2, enabling support for charge balancing in feedback applications such as delta-sigma modulators.

Fig. 1B shows the timing diagram of the clock phases used to control the switches in circuit 100. Clock phases φ0, φ1, φ1A , φ2, and φ2A are illustrated, each representing a non-overlapping control signal that defines a distinct operating phase. Region 101 corresponds to the switching scheme for the sampling phase, 102 corresponds to the switching scheme for the discharging phase, and 103 corresponds to the switching scheme for the integration phase. The transitions between clock phases are separated by short delays to prevent overlap, thereby avoiding direct short circuits or charge sharing between switching paths. As it is partially shown in Fig. 1B, the timing sequence repeats after the end of the integration phase, starting again with the sampling phase.

The timing sequence shown in Fig. 1B enables deterministic and sequential operation of the integrator, ensuring that the auxiliary capacitor C_{S,AUX} contributes to thermal noise performance during sampling, is properly reset during discharging, and that only the primary capacitor Cs defines the effective gain during integration. This configuration facilitates a decoupling of gain and noise constraints, allowing for area-efficient integrator design suitable for use in delta-sigma modulators and other low-power, high-resolution analog-to-digital conversion systems.

Figs. 2A-C illustrate the three successive operating phases of the switched-capacitor integrator circuit 100 previously shown in Fig. 1A. Each subfigure highlights the relevant switch configurations and current paths associated with the sampling, discharging, and integration phases, respectively.

Fig. 2A shows the circuit during the sampling phase. In this phase, clock signals φ0, φ1, and φ1A are active, thereby closing the corresponding switches controlled by these clock signals. The input signal Vin is connected through the closed φ1 switch to the bottom terminal of the primary sampling capacitor Cs and the switch associated to the clock signal φ0 allows the input signal to be connected to both the bottom terminals of the primary sampling capacitor and the auxiliary sampling capacitor. The top terminals of both Cs and the auxiliary capacitor C_{S,AUX} are connected to a virtual AC ground via φ1A. This configuration allows both capacitors to sample the input signal in parallel. The charge stored across both capacitors during this phase defines the total sampled charge and primarily influences the integrator's noise performance.

Fig. 2B shows the circuit during the discharging phase. Clock signal φ1A is activated, closing the path from both the bottom plates of the auxiliary sampling capacitor C_{S,AUX} and the primary sampling capacitor Cs to a virtual ground. Simultaneously, the switch controlled by the complementary of the clock signal φ0, namely /φ0 is closed, which provides a discharging path for the charges stored on the auxiliary sampling capacitor C_{S,AUX} to a virtual ground. This configuration ensures that the auxiliary capacitor is discharged to a well-defined potential. The red arrows indicate the direction of charge flow out of C_{S,AUX}. Importantly, the discharging step prepares the auxiliary sampling capacitor for its role in the next cycle and enables the integrator to achieve a decoupling between gain and noise performance.

Fig. 2C shows the integration phase. During this phase, clock signal φ2 is activated. The bottom plate of C_{S} is now connected to a well-defined DC potential, being an AC virtual ground, supplying a reference voltage V_{DAC}, while its top plate is connected to the integration capacitor. The charge stored on C_{S} is transferred to the integration capacitor Cᵢₙₜ. Although C_{S,AUX} has been discharged in the previous phase, it remains electrically present in the circuit during the integration phase, contributing to the total capacitive loading seen by the OTA input. This presence helps maintain the desired thermal noise characteristics without influencing the effective gain, which is set by the ratio C_{S}/Cᵢₙₜ. The red arrows again indicate the direction of charge transfer.

Together, these figures demonstrate the phase-wise charge handling behavior of the integrator, including how the separation of sampling and integration roles across two capacitors enables enhanced noise performance while maintaining gain control and area efficiency.

Figs. 3A through 3C illustrate equivalent noise models for the switched-capacitor integrator circuit described previously, for each of the three main operating phases: sampling, discharging, and integration. These models are used to demonstrate that the proposed integrator architecture maintains noise performance comparable to conventional configurations, despite the introduction of a separate discharging phase and the use of dual sampling capacitive elements.

Fig. 3A shows the equivalent noise circuit during the sampling phase. The primary sampling capacitor C_{S} and the auxiliary sampling capacitor C_{S,AUX} are connected in parallel, therefore the total sampling capacitance is the sum of the two. This combined capacitance limits the noise bandwidth (NBW) of the sampling circuit. The resistive noise sources shown in the figure represent the thermal noise introduced by the sampling switches. The architecture thus maintains a noise profile equivalent to a traditional integrator that uses a single large sampling capacitor with equivalent total capacitance. In this phase, the noise bandwidth is defined as NBW₁=1/4R(C_{S}+C_{S,AUX}), with R being the on-resistance of each switch, also defined as resistive noise sources, as shown in Figs. 3A-C.

Fig. 3B shows the discharging phase, during which the auxiliary capacitor C_{S,AUX} is isolated from the input signal and discharged to a virtual ground. Under a first-order approximation, the noise bandwidth in the discharging phase is similar to that in the sampling phase, as the same total capacitance (dominated by C_{S,AUX}) governs the RC time constant. This confirms that the discharging phase does not introduce a noise penalty compared to the sampling phase. The completeness of the discharge is important primarily to minimize gain error, not noise degradation. If the discharging phase is too short, residual charge may remain on C_{S,AUX} and be transferred to the integration capacitor in the next phase. This would cause a gain error proportional to the ratio C_{S,AUX}/C_{S}, but not a significant linearity degradation, as confirmed by simulation and analysis. The error may be kept below design tolerances by increasing the discharging time.

Fig. 3C shows the equivalent circuit during the integration phase, where the primary sampling capacitor Cs is connected to the inverting input of the operational transconductance amplifier (OTA). The auxiliary capacitor C_{S,AUX}, although previously discharged, remains electrically present in the input network and continues to contribute to the total capacitive loading at the OTA input. As a result, the total capacitance that defines the noise bandwidth in this phase remains approximately C_{S}+C_{S,AUX}, preserving the noise behavior seen in the sampling phase. The integration capacitor Cᵢₙₜ is connected between the output and the inverting input of the OTA. Also shown is an equivalent voltage noise source V_{n,OTA} and transconductance block 1/Gₘ, representing the OTA's input referred noise and input impedance.

These equivalent models illustrate that the proposed integrator architecture retains the same effective noise behavior as conventional switched-capacitor integrators. By sampling the input on both capacitors and selectively discharging only the auxiliary sampling capacitor, the design enables a separation between gain setting and noise performance, offering flexibility in optimizing area, power, and resolution in integrator, and more generally in delta-sigma modulator designs.

### Further details

1. A switched capacitor integrator for discrete-time delta-sigma modulators comprising an input terminal and an output terminal, such as an input port and an output port configured to receive an input signal and to generate an output signal, respectively, wherein the switched capacitor integrator comprises a first integrator circuit comprising:
   one or more sampling capacitive element, wherein said one or more sampling capacitive element comprises a primary sampling capacitive element and an auxiliary sampling capacitive element,
   a plurality of switches,
   an operational amplifier comprising a positive input port, a negative input port and an amplifier output port,
   an integration capacitive element arranged between the negative input port and the amplifier output port,
   wherein the plurality of switches are configured to sample, discharge and/or transfer charges during at least three phases comprising a sampling phase, a discharging phase and an integration phase, wherein the sampling phase is configured to sample a sampling charge from the input terminal to the one or more sampling capacitive element, the discharging phase is configured to discharge an auxiliary charge from the auxiliary sampling capacitive element to a virtual ground and the integration phase is configured to transfer an integration charge from the one or more sampling capacitive elements to the integration capacitive element.
2. The switched capacitor integrator according to item 1, wherein the plurality of switches are individually controlled.
3. The switched capacitor integrator according to any one of the preceding items, wherein the integration capacitive element and/or the one or more sampling capacitive element comprise an integration capacitor and/or one or more sampling capacitor, and wherein the primary sampling capacitive element and the auxiliary sampling capacitive element comprise a primary sampling capacitor and an auxiliary sampling capacitor, respectively.
4. The switched capacitor integrator according to item 3, wherein the integration capacitor and/or the one or more sampling capacitor are implemented using CMOS-compatible structures, such as metal-insulator-metal (MiM), metal-oxide-metal (MoM) and/or MOS capacitors.
5. The switched capacitor integrator according to any one of the preceding items, further comprising a master clock, wherein the master clock is configured to provide a plurality of clock signals configured to control the plurality of switches.
6. The switched capacitor integrator according to any one of the preceding items, wherein the at least three phases occur in time in the following order, the sampling phase, the discharging phase and the integration phase.
7. The switched capacitor integrator according to any one of the preceding items, wherein the plurality of switches comprises a first part, a second part and a third part of switches.
8. The switched capacitor integrator according to any one of the preceding items, wherein the virtual ground is an alternative current (AC) ground.
9. The switched capacitor integrator according to any one of the preceding items, wherein the sampling phase is configured to cause the plurality of switches to form a series connection between the input terminal, the one or more sampling capacitive elements arranged in parallel, and a sampling virtual ground, wherein the sampling virtual ground is a sampling AC ground.
10. The switched capacitor integrator according to any one of the preceding items, wherein the discharging phase is configured to cause the plurality of switches to form at least one series connection between the input terminal, the virtual ground and/or the sampling virtual ground, thereby discharging the charges of the auxiliary sampling capacitive element into the virtual ground and/or the sampling virtual ground.
11. The switched capacitor integrator according to any one of the preceding items, wherein the integration phase is configured to cause the plurality of switches to form a series connection between at least one virtual ground, the one or more sampling capacitive elements, the integration capacitive element and the output terminal, thereby transferring the integration charge from the one or more sampling capacitive elements to the integration capacitive element.
12. The switched capacitor integrator according to item 11, wherein the primary sampling capacitive element is connected to a primary virtual ground, such as a primary alternative current (AC) ground, preferably a primary direct current (DC) bias.
13. The switched capacitor integrator according to any one of the preceding items, wherein the operational amplifier is configured to have the one or more sampling capacitive elements and/or the integration capacitive elements connected to its negative input via the plurality of switches, and wherein the positive input is connected to a local AC ground.
14. The switched capacitor integrator according to any one of the preceding items, wherein each of the plurality of switches are CMOS-based switches.
15. The switched capacitor integrator according to any one of the preceding items, wherein the CMOS-based switches are transmission gates, or wherein each one of the CMOS-based switches are implemented using a single NMOS and/or a single PMOS transistor, such as a bootstrapped NMOS transistor. comprising a NMOS and a PMOS.
16. The switched capacitor integrator according to any one of the preceding items, wherein the plurality of switches comprises at least six switches, such as a first, a second, a third, a fourth, a fifth and a sixth switches.
17. The switched capacitor integrator according to any one of the preceding items, wherein the first switch is configured to connect or disconnect the primary sampling capacitive element to the input terminal.
18. The switched capacitor integrator according to any one of the preceding items, wherein the second switch is configured to connect or disconnect the primary sampling capacitive element to the primary virtual ground, preferably the primary AC ground, more preferably the primary DC bias.
19. The switched capacitor integrator according to any one of the preceding items, wherein the third switch is configured to connect or disconnect the primary sampling capacitive element to the auxiliary sampling capacitive element.
20. The switched capacitor integrator according to any one of the preceding items, wherein the fourth switch is configured to connect or disconnect the auxiliary sampling capacitive element to the virtual ground.
21. The switched capacitor integrator according to any one of the preceding items, wherein the fifth switch is configured to connect the one or more sampling capacitive element to the integration capacitive element and/or the negative input port of the operational amplifier.
22. The switched capacitor integrator according to any one of the preceding items, wherein the sixth switch is configured to connect the one or more sampling capacitive element to the sampling virtual ground, preferably the sampling AC ground, more preferably the sampling DC bias.
23. The switched capacitor integrator according to any one of the preceding items, wherein the second switch and the fifth switch are controlled by a second control signal.
24. The switched capacitor integrator according to any one of the preceding items, wherein the third switch and the fourth switch are controlled by complementary signals, such that a first control signal is split into two complementary signals, each controlling one of the third switch and the fourth switch.
25. The switched capacitor integrator according to any one of the preceding items, wherein the sampling phase is configured to close the first, the third and the sixth switches and open the second, the fourth and the fifth switches.
26. The switched capacitor integrator according to any one of the preceding items, wherein the discharging phase is configured to close the fourth, the first and the sixth switches and open the third, the second and the fifth switches.
27. The switched capacitor integrator according to any one of the preceding items, wherein the integration phase is configured to close the fourth, the second and the fifth switch and open the first, the third and the sixth switches.
28. The switched capacitor integrator according to any one of the preceding items, wherein the operational amplifier is an operational transconductance amplifier (OTA).
29. The switched capacitor integrator according to any one of the preceding items, wherein the operational amplifier is a fully differential operational amplifier, such as a fully differential operational transconductance amplifier.
30. The switched capacitor integrator according to any one of the preceding items, wherein the fully differential operational amplifier comprises a differential amplifier input and a differential amplifier output.
31. The switched capacitor integrator according to any one of the preceding items, further comprising a second integrator circuit, wherein the second integrator circuit comprises the same features as the first integrator circuit.
32. The switched capacitor integrator according to any one of the preceding items, wherein at least two of the plurality of switches are configured to provide a common-mode direct current (DC) voltage, and wherein one of the at least two of the plurality of switches is arranged between a common-mode voltage port and the positive input port, and another one of the at least two of the plurality of switches is arranged between the common-mode DC voltage port and the negative input port.
33. The switched capacitor integrator according to any one of the preceding items, wherein the primary sampling capacitor and/or the auxiliary sampling capacitor have a primary sampling capacitance and an auxiliary sampling capacitance, respectively, and wherein the ratio between the auxiliary sampling capacitance and the primary sampling capacitance is greater than one, such as equal to or greater than 2, such as equal to or greater than 3, such as equal to or greater than 4, such as equal to or greater than 5, such as equal to or greater than 10.
34. A delta-sigma modulator comprising the switched capacitor integrator according to any one of the preceding items, wherein the delta-sigma modulator further comprises a quantizer and a digital-to-analog converter (DAC) configured to convert a digital output signal coming from the quantizer into a feedback signal, wherein the feedback signal is provided as a feedback input of the integrator.
35. The delta-sigma modulator according to item 34, wherein the delta-sigma modulator further comprises a positive voltage reference and a negative voltage reference, wherein the positive voltage reference and the negative voltage reference can be supplied to the one or more sampling capacitors through a positive voltage reference switch and a negative voltage reference switch, respectively, and wherein the positive voltage reference switch and the negative voltage reference switch have the same features as the plurality of switches.
36. A method of operating a switched capacitor integrator for discrete-time delta-sigma modulator, wherein the method comprises the steps of:
   providing a switched capacitor integrator for discrete-time delta-sigma modulators comprising an input terminal and an output terminal, such as an input port and an output port configured to receive an input signal and to generate an output signal, respectively, wherein the switched capacitor integrator comprises a first integrator circuit comprising:
      one or more sampling capacitive element, wherein said one or more sampling capacitive element comprises a primary sampling capacitive element and an auxiliary sampling capacitive element,
      a plurality of switches,
      an operational amplifier comprising a positive input port, a negative input port and an amplifier output port,
      an integration capacitive element arranged between the negative input port and the amplifier output port,
   sampling, during a sampling phase the input signal in the primary and the auxiliary sampling capacitive elements,
   disconnecting, via the plurality of switches, the auxiliary sampling capacitive element from the input signal,
   connecting and thereby discharging, via the plurality of switches, during a discharging phase, the auxiliary sampling capacitive element to a virtual ground, and
   transferring, during an integration phase, an integration charge from the one or more sampling capacitive element to the integration capacitive element.
37. The method according to item 36, wherein the discharging phase is between the sampling phase and the integration phase.
38. The method according to item 36, wherein the virtual ground is a virtual alternative current (AC) ground.
39. The method according to any one of items 36-38, wherein the plurality of switches comprises a first, a second and a third set of one or more switch.
40. The method according to any one of items 36-39, wherein the first set of one or more switch is forming a sampling path between the input terminal, the primary sampling capacitor and the auxiliary sampling capacitor arranged in parallel, and a sampling virtual ground, during the sampling phase.
41. The method according to item 40, wherein the sampling virtual ground is a sampling alternative current (AC) ground.
42. The method according to any one of items 36-41, wherein the second set of one or more switch is forming a discharging path between the input terminal, the primary sampling capacitor, the auxiliary sampling capacitor, and the virtual ground, during the discharging phase.
43. The method according to any one of items 36-42, wherein the second set of one or more switch is further forming a series connection between the one or more sampling capacitors arranged in parallel and the sampling virtual ground.
44. The method according to any one of items 36-43, wherein the third set of one or more switch is forming an integration path between the output terminal, the integration capacitor, the primary sampling capacitor and a primary AC ground.
45. The method according to item 44, wherein the third set of one or more switch is further forming a series connection between the integration capacitor, the auxiliary sampling capacitor, and the virtual ground.
46. The method according to any one of items 36-45, wherein the switched capacitor integrator is the switched capacitor integrator according to any one of items 1-33.

## Claims

1. A switched capacitor integrator for discrete-time delta-sigma modulators comprising an input terminal and an output terminal, such as an input port and an output port configured to receive an input signal and to generate an output signal, respectively, wherein the switched capacitor integrator comprises a first integrator circuit comprising:
one or more sampling capacitive element, wherein said one or more sampling capacitive element comprises a primary sampling capacitive element and an auxiliary sampling capacitive element,
a plurality of switches,
an operational amplifier comprising a positive input port, a negative input port and an amplifier output port,
an integration capacitive element arranged between the negative input port and the amplifier output port,
wherein the plurality of switches are configured to sample, discharge and/or transfer charges during at least three phases comprising a sampling phase, a discharging phase and an integration phase, wherein the sampling phase is configured to sample a sampling charge from the input terminal to the one or more sampling capacitive element, the discharging phase is configured to discharge an auxiliary charge from the auxiliary sampling capacitive element to a virtual ground and the integration phase is configured to transfer an integration charge from the one or more sampling capacitive elements to the integration capacitive element.

2. The switched capacitor integrator according to any one of the preceding claims, wherein the integration capacitive element and/or the one or more sampling capacitive element comprise an integration capacitor and/or one or more sampling capacitor, and wherein the primary sampling capacitive element and the auxiliary sampling capacitive element comprise a primary sampling capacitor and an auxiliary sampling capacitor, respectively.

3. The switched capacitor integrator according to any one of the preceding claims, wherein the at least three phases occur in time in the following order, the sampling phase, the discharging phase and the integration phase.

4. The switched capacitor integrator according to any one of the preceding claims, wherein the sampling phase is configured to cause the plurality of switches to form a series connection between the input terminal, the one or more sampling capacitive elements arranged in parallel, and a sampling virtual ground, wherein the sampling virtual ground is a sampling AC ground.

5. The switched capacitor integrator according to any one of the preceding claims, wherein the discharging phase is configured to cause the plurality of switches to form at least one series connection between the input terminal, the virtual ground and/or the sampling virtual ground, thereby discharging the charges of the auxiliary sampling capacitive element into the virtual ground and/or the sampling virtual ground.

6. The switched capacitor integrator according to any one of the preceding claims, wherein the integration phase is configured to cause the plurality of switches to form a series connection between at least one virtual ground, the one or more sampling capacitive elements, the integration capacitive element and the output terminal, thereby transferring the integration charge from the one or more sampling capacitive elements to the integration capacitive element.

7. The switched capacitor integrator according to any one of the preceding claims, wherein the operational amplifier is configured to have the one or more sampling capacitive elements and/or the integration capacitive elements connected to its negative input via the plurality of switches, and wherein the positive input is connected to a local AC ground.

8. The switched capacitor integrator according to any one of the preceding claims, wherein the plurality of switches comprises at least six switches, such as a first, a second, a third, a fourth, a fifth and a sixth switches, wherein the first switch is configured to connect or disconnect the primary sampling capacitive element to the input terminal, wherein the second switch is configured to connect or disconnect the primary sampling capacitive element to the primary virtual ground, preferably the primary AC ground, more preferably the primary DC bias, wherein the third switch is configured to connect or disconnect the primary sampling capacitive element to the auxiliary sampling capacitive element, wherein the fourth switch is configured to connect or disconnect the auxiliary sampling capacitive element to the virtual ground, wherein the fifth switch is configured to connect the one or more sampling capacitive element to the integration capacitive element and/or the negative input port of the operational amplifier, wherein the sixth switch is configured to connect the one or more sampling capacitive element to the sampling virtual ground, preferably the sampling AC ground, more preferably the sampling DC bias.

9. The switched capacitor integrator according to any one of the preceding claims, wherein the second switch and the fifth switch are controlled by a second control signal and wherein the third switch and the fourth switch are controlled by complementary signals, such that a first control signal is split into two complementary signals, each controlling one of the third switch and the fourth switch.

10. The switched capacitor integrator according to any one of the preceding claims, wherein the operational amplifier is a fully differential operational amplifier, such as a fully differential operational transconductance amplifier, wherein the fully differential operational amplifier comprises a differential amplifier input and a differential amplifier output and wherein the switched capacitor integrator further comprises a second integrator circuit, wherein the second integrator circuit comprises the same features as the first integrator circuit.

11. The switched capacitor integrator according to any one of the preceding claims, wherein the primary sampling capacitor and/or the auxiliary sampling capacitor have a primary sampling capacitance and an auxiliary sampling capacitance, respectively, and wherein the ratio between the auxiliary sampling capacitance and the primary sampling capacitance is greater than one, such as equal to or greater than 2, such as equal to or greater than 3, such as equal to or greater than 4, such as equal to or greater than 5, such as equal to or greater than 10.

12. A delta-sigma modulator comprising the switched capacitor integrator according to any one of the preceding claims, wherein the delta-sigma modulator further comprises a quantizer and a digital-to-analog converter (DAC) configured to convert a digital output signal coming from the quantizer into a feedback signal, wherein the feedback signal is provided as a feedback input of the integrator, wherein the delta-sigma modulator further comprises a positive voltage reference and a negative voltage reference, wherein the positive voltage reference and the negative voltage reference can be supplied to the one or more sampling capacitors through a positive voltage reference switch and a negative voltage reference switch, respectively, and wherein the positive voltage reference switch and the negative voltage reference switch have the same features as the plurality of switches.

13. A method of operating a switched capacitor integrator for discrete-time delta-sigma modulator, wherein the method comprises the steps of:
providing a switched capacitor integrator for discrete-time delta-sigma modulators comprising an input terminal and an output terminal, such as an input port and an output port configured to receive an input signal and to generate an output signal, respectively, wherein the switched capacitor integrator comprises a first integrator circuit comprising:
one or more sampling capacitive element, wherein said one or more sampling capacitive element comprises a primary sampling capacitive element and an auxiliary sampling capacitive element,
a plurality of switches,
an operational amplifier comprising a positive input port, a negative input port and an amplifier output port,
an integration capacitive element arranged between the negative input port and the amplifier output port,
sampling, during a sampling phase the input signal in the primary and the auxiliary sampling capacitive elements,
disconnecting, via the plurality of switches, the auxiliary sampling capacitive element from the input signal,
connecting and thereby discharging, via the plurality of switches, during a discharging phase, the auxiliary sampling capacitive element to a virtual ground, and
transferring, during an integration phase, an integration charge from the one or more sampling capacitive element to the integration capacitive element.

14. The method according to claim 13, wherein the discharging phase is between the sampling phase and the integration phase.

15. The method according to any one of claims 13-14, wherein the plurality of switches comprises a first, a second and a third set of one or more switch, wherein the first set of one or more switch is forming a sampling path between the input terminal, the primary sampling capacitor and the auxiliary sampling capacitor arranged in parallel, and a sampling virtual ground, during the sampling phase, wherein the second set of one or more switch is forming a discharging path between the input terminal, the primary sampling capacitor, the auxiliary sampling capacitor, and the virtual ground, during the discharging phase, wherein the second set of one or more switch is further forming a series connection between the one or more sampling capacitors arranged in parallel and the sampling virtual ground, wherein the third set of one or more switch is forming an integration path between the output terminal, the integration capacitor, the primary sampling capacitor and a primary AC ground and wherein the third set of one or more switch is further forming a series connection between the integration capacitor, the auxiliary sampling capacitor, and the virtual ground.
